# EUROPEAN PATENT APPLICATION

(11) **EP 4 732 973 A1**
(43) Date of publication of application: **29.04.2026**
(21) Application number: 24826007.7
(22) Date of filing: 21.06.2024
(51) Int. Cl.: B23B 27/14, B23C 5/10, B23C 5/16, C23C 14/06

(54) **COATED CUTTING TOOL**

(30) Priority: 23.06.2023 JP 2023103054
(71) Applicant: MOLDINO Tool Engineering, Ltd., Tokyo 130-0026 (JP)
(72) Inventor: FUWA Ryoutarou, Yasu-shi, Shiga 520-2323 (JP)
(74) Representative: Hoffmann Eitle
(86) International application number: PCT/JP2024/022549
(87) International publication number: WO 2024/262606

(57) **Abstract**

A coated cutting tool including: a base material; and a hard coat over the base material. The hard coat is a nitride or a carbonitride containing titanium (Ti) at 60 atom% or more and 95 atom% or less and silicon (Si) at 5 atom% or more and 40 atom% or less with respect to the total amount of metals including a metalloid. In the hard coat, in a case where a total of metal elements including a metalloid, and non-metal elements is set to 100 atom%, an atomic ratio (atom%) A of the metal elements including the metalloid and an atomic ratio (atom%) B of nitrogen satisfy a relationship of 1.1 < B/A. In the hard coat, a crystal structure is a cubic crystal and a full width at half maximum of a (200) plane of the cubic crystal in X-ray diffraction is 0.75° or more and 1.10° or less.

## Description

### TECHNICAL FIELD

The present invention relates to a coated cutting tool.

Priority is claimed on Japanese Patent Application No. 2023-103054, filed June 23, 2023, the content of which is incorporated herein by reference.

### BACKGROUND ART

A TiSi nitride is a type of film excellent in wear resistance and is applied to coated cutting tools (for example, see Patent Documents 1 and 2).

### Citation List

### Patent Documents

Patent Document 1: Japanese Unexamined Patent Application, First Publication No. 2000-334606
Patent Document 2: PCT International Publication No. WO2014/156699

### SUMMARY OF INVENTION

### Technical Problem

According to the studies of the present inventors, it has been confirmed that there is room for improvement in durability of a TiSi nitride coated by an arc ion plating method in the related art.

### Solution to Problem

An aspect of the present invention is a coated cutting tool including a base material; and a hard coat over the base material, in which the hard coat is a nitride or a carbonitride containing titanium (Ti) at 60 atom% or more and 95 atom% or less and silicon (Si) at 5 atom% or more and 40 atom% or less with respect to a total amount of metals including a metalloid, and in the hard coat, in a case where a total of metal elements including a metalloid, and non-metal elements is set to 100 atom%, an atomic ratio (atom%) A of the metal elements including the metalloid and an atomic ratio (atom%) B of nitrogen satisfy a relationship of 1.1 < B/A, and a crystal structure is a cubic crystal and a full width at half maximum of a (200) plane of the cubic crystal in X-ray diffraction is 0.75° or more and 1.10° or less.

It is preferable that in observation of a surface or a cross section of the hard coat, the number of droplets having an equivalent circular diameter of 3 µm or more is 5 or less in a range of 50 µm × 40 µm.

The coated cutting tool may include an interlayer coat provided between the hard coat and the base material.

### Advantageous Effects of Invention

According to the present invention, it is possible to provide a coated cutting tool having excellent durability.

### BRIEF DESCRIPTION OF DRAWINGS

FIG. 1 is an example of a surface observation photograph (×2,000 times) of a hard coat according to the present example.
FIG. 2 is an example of a surface observation photograph (×2,000 times) of a hard coat according to a conventional example.

### DESCRIPTION OF EMBODIMENTS

The present inventors have found that, in a nitrogen-rich TiSi nitride, the excellent durability is exhibited by controlling a full width at half maximum of a (200) plane of a cubic crystal within a certain range, and have reached the present invention. Hereinafter, details of the present embodiment will be described.

Hereinafter, the details of the embodiment of the present invention will be described.

The coated cutting tool of the present embodiment is a coated cutting tool having a hard coat consisting of a nitride or a carbonitride of TiSi on a surface of the tool base material.

Details of the component composition, structure, characteristics, manufacturing method, and the like of the hard coat constituting the coated cutting tool of the present embodiment will be described.

In the coated cutting tool of the present embodiment, the base material is not particularly limited, and it is preferable that a WC-Co-based cemented carbide having excellent strength and toughness is used as the base material.

### <Component composition: titanium (Ti), silicon (Si)>

The hard coat according to the present embodiment consists of a nitride or a carbonitride containing titanium (Ti) at 60 atom% or more and 95 atom% or less and silicon (Si) at 5 atom% or more and 40 atom% or less with respect to the total amount of metals elements including a metalloid.

A nitride or a carbonitride of TiSi is a type of film excellent in wear resistance. The hard coat according to the present embodiment is defined to contain 60 atom% or more and 95 atom% or less of titanium (Ti) to ensure wear resistance and heat resistance. The titanium (Ti) is contained preferably at 65 atom% or more and 90 atom% or less.

The hard coat according to the present embodiment is defined to contain 5 atom% or more and 40 atom% or less of silicon (Si) to refine the structure while ensuring toughness. The silicon (Si) is contained preferably at 10 atom% or more and 35 atom% or less.

### <Atomic ratio A of metal element and atomic ratio B of nitrogen>

In the hard coat according to the present embodiment, in a case where a total of the metal elements including the metalloid, and a non-metal element is set to 100 atom%, an atomic ratio A of the metal element including the metalloid and an atomic ratio B of nitrogen satisfy the relationship of 1.1 < B/A. The non-metal element may be carbon or oxygen in addition to nitrogen. It is presumed that in a case where the value of B/A is larger than 1.1, a complete nitride is sufficiently formed at a micro level. The B/A is preferably more than 1.15. On the other hand, in a case where the value of B/A is too large, the coat is likely to be damaged. The B/A is preferably less than 1.3, and preferably less than 1.25. Furthermore, the B/A is preferably more than 1.15 and less than 1.25.

The composition of the hard coat according to the present embodiment can be determined by measuring the mirror-finished hard coat using an electron probe microanalyzer (EPMA) device. In this case, for example, after a surface of the hard coat is mirror-finished, analysis is performed at five points where each analysis range is approximately 1 µm in diameter, and the composition can be obtained from an average value of the analysis results.

### <Crystal structure>

The hard coat according to the present embodiment has a crystal structure of a cubic crystal. The hard coat according to the present embodiment has a full width at half maximum of X-ray diffraction peak of the (200) plane of the cubic crystal in X-ray diffraction of 0.75° or more and 1.10° or less. In a nitrogen-rich TiSi nitride, a full width at half maximum of a (200) plane of a cubic crystal is 0.75° or more and 1.10° or less, and the durability tends to be excellent. In the hard coat according to the present embodiment, it is preferable that the full width at half maximum of the X-ray diffraction peak of the (200) plane of the cubic crystal is 0.8° or more. In the hard coat according to the present embodiment, it is preferable that the full width at half maximum of the X-ray diffraction peak of the (200) plane of the cubic crystal is 1.0° or less.

The hard coat according to the present embodiment may contain one or more types of elements selected from metal elements other than Ti and Si, and metalloid elements, within a range satisfying the above-described requirements. For example, one or two or more elements selected from elements of Group IVa, Group Va, and Group VIa of the periodic table, B, Y, Cu for the purpose of improving the wear resistance, heat resistance, lubricity, or the like of the hard coat. These elements are elements generally added to improve the characteristics of the hard coat, and the durability of the coated cutting tool is not significantly reduced as long as the content ratio thereof is not excessive. In a case where the hard coat according to the present embodiment contains one or more types of elements selected from metal elements other than Ti and Si, and metalloid elements, a total content ratio thereof is preferably 20 atom% or less. Furthermore, the total content ratio is preferably 10 atom% or less.

In the observation of the surface or the cross section of the hard coat according to the present embodiment, the number of droplets having an equivalent circular diameter of 3 µm or more is 5 or less in a range of 50 µm × 40 µm. Furthermore, it is preferably 2 or less. In an arc ion plating method, droplets according to the invention are deposits on the hard coat caused by molten particles of approximately 1 to several tens of µm flying out from a cathode. The durability of the tool is improved by reducing the coarse droplets contained in the hard coat. Furthermore, in the observation of the surface or the cross section of the hard coat according to the present embodiment, it is preferable that the number of droplets having an equivalent circular diameter of 5 µm or more is 1 or less in a range of 50 µm × 40 µm. The durability of the tool is improved by reducing the more coarse droplets.

The droplets of the hard coat may be observed at a magnification of 2,000 with an electron microscope, and the average may be determined by observing five or more fields of view each having an area of 50 µm × 40 µm.

A film thickness of the hard coat according to the present embodiment is preferably 0.3 µm or more and 5 µm or less.

The coated cutting tool according to the present embodiment may be provided with an interlayer coat between the base material and the hard coat, as necessary. For example, an AlTi-based or AlCr-based nitride or carbonitride may be provided as the interlayer coat. The interlayer coat is preferably a nitride or a carbonitride containing Al at 40 atom% or more and 70 atom% or less and one or more types of Ti and Cr at 30 atom% or more and 60 atom% or less. A plurality of interlayer coats may be provided. The interlayer coat may be a laminated coat. A modified layer may be provided on the base material surface by metal bombardment.

An upper layer may be provided on the hard coat of the coated cutting tool according to the present embodiment as necessary. For example, an AlTi-based or AlCr-based nitride or carbonitride may be provided on the upper layer. A material other than the nitride or the carbonitride may be provided.

The hard coat according to the present embodiment is a physical vapor deposition film. The hard coat according to the present embodiment is preferably a hard coat coated by an arc ion plating method, which is a physical vapor deposition film having excellent adhesiveness. It is preferable that the coated cutting tool according to the present embodiment is coated using a film deposition apparatus including a cathode having permanent magnets disposed on a rear surface and an outer peripheral surface of a target, and further having a magnetic field generating coil disposed in front of the target to generate a magnetic field that pushes plasma forward. In addition, it is preferable that a distance from the target surface to the base material is 250 mm or more. As the distance from the target surface to the base material is longer, the coarse droplets reaching the base material tend to be reduced.

The coating temperature is preferably 450°C to 550°C. The negative bias voltage applied to the base material is preferably -90 to -30 V. The pressure inside the furnace is preferably 2 to 8 Pa. The input current to the target is preferably 100 to 200 A. The input power to the magnetic field generating coil is preferably 3 to 10 A. Examples

### <base material>

As the base material, a two-flute ball end mill made of a cemented carbide having a composition of WC (bal.)-Co (8% by mass)-Cr (0.5% by mass)-VC (0.3% by mass), an average WC grain size of 0.6 µm, and a hardness of 93.9 HRA was prepared.

### <Manufacturing method>

For film formation, a film deposition apparatus of an arc ion plating method was used. The device includes a plurality of cathodes (arc evaporation sources), a vacuum container, and a base material rotation mechanism.

The apparatus used for coating in the present example and the comparative example includes a cathode in which a permanent magnet is disposed on a rear surface and an outer peripheral surface of a target, and a magnetic field generating coil that generates a magnetic field for pushing plasma forward is provided in front of the target. In addition, the cathode includes a filter mechanism that can reduce droplets by a magnetic field. In addition, the distance from the target surface to the base material is 400 mm.

The inside of the vacuum container is evacuated by a vacuum pump, and the gas is introduced from a supply port. The base material installed in the vacuum container is connected to a bias power supply, and a negative bias voltage is independently applied to the base material.

In the base material rotation mechanism, a work table, a plate-shaped jig on the work table, and a pipe-shaped jig on the plate-shaped jig are attached, the work table rotates at a speed of 3 rotations per minute, and the plate-shaped jig and the pipe-shaped jig each perform both rotation and revolution.

### <Heating and vacuum evacuation step>

The base material was fixed to the pipe-shaped jig in the vacuum container, and the pre-deposition process was performed as follows. First, the inside of the vacuum container was vacuum-exhausted to 5×10⁻³ Pa or lower. Thereafter, the base material was heated up to a temperature of 500°C with a heater installed in the vacuum container, and the vacuum container was vacuum-exhausted. As a result, the base material temperature was set to 500°C, and the pressure in the vacuum container was set to 5 × 10⁻³ Pa or less.

### <Ar bombardment step>

Thereafter, an argon (Ar) gas was introduced into the vacuum container, and the pressure inside the vacuum container was set to about 0.50 Pa. Subsequently, a current of 20 A was supplied to a filament electrode, a negative bias voltage of -150 V was applied to the base material, and Ar bombardment was performed for 60 minutes.

### <Deposition process>

After the Ar bombardment, the gas in the vacuum container was replaced with nitrogen, and the pressure in the vacuum container was set to 4 Pa. A current of 100 A was supplied to a AlCr target, a current of 5 A was supplied to the magnetic field generating coil, and a bias voltage of -150 V was applied to the base material to coat an interlayer coat of an AlCr nitride with about 2 µm.

Subsequently, a current of 150 A was supplied to the TiSi target, a bias voltage of -50 V was applied to the base material, and the power supplied to the magnetic field generating coil by the sample and the gas pressure were changed to coat a hard coat of a Ti75Si25 (the numerical value is an atomic ratio) nitride with about 1 µm.

The apparatus used for coating in the conventional example includes a cathode in which a permanent magnet is disposed on a rear surface and an outer peripheral surface of a target. The distance from the target surface to the base material is 170 mm. The deposition conditions were the same as those of the coating of the present Example 1 described above, except that there was no current input to the magnetic field generating coil.

### <<Composition analysis>>

The coat composition was measured using wavelength dispersive electron probe microanalysis (WDS-EPMA) attached to an electron probe microanalyzer (JXA-8500F, manufactured by JEOL Ltd.). The ball end mill for physical property evaluation was mirror-finished, and the measurement was performed at an acceleration voltage of 10 kV, an irradiation current of 5 × 10⁻⁸ A, and an acquisition time of 10 seconds, and the average value of five points in a range of a diameter of about 1 µm was determined as the composition.

Confirmation was performed using an X-ray diffractometer (Empyrea manufactured by PaNalytical Ltd.) under measurement conditions of a tube voltage of 45 kV, a tube current of 40 mA, an X-ray source of Cuk α (λ = 0.15405 nm), and 2θ in a range of 20 to 80 degrees.

### (Condition) Dry processing

Tool: two-flute carbide ball end mill
Model number: EPDBE2010-6, ball radius of 0.5 mm
Cutting method: Bottom cutting
Work material: STAVAX (52 HRC) (manufactured by Bohler-Uddeholm Co., Ltd.)
Depth of cut: 0.03 mm in an axial direction, 0.03 mm in a radial direction
Cutting speed: 67.8 m/min
One blade feed amount: 0.0135 mm/blade
Cutting distance: 5m
Evaluation method: After cutting, the work material was observed using a scanning electron microscope at a magnification of 1000 times to measure widths of abrasion between the tool and the work material on a flank face of the tool, and a portion having the largest abrasion width thereamong was defined as a flank face maximum wear width.

**[Table 1]**

| | Coil current (A) | Pressure inside furnace (Pa) | B/A | Full width at half maximum of (200) plane (°) | Maximum wear width (µm) |
|---|---|---|---|---|---|
| Present Example 1 | 8 | 3 | 1.20 | 0.9192 | 4 |
| Present Example 2 | 6 | 3 | 1.19 | 0.8795 | 3 |
| Present Example 3 | 4 | 3 | 1.20 | 0.7680 | 4 |
| Present Example 4 | 8 | 2 | 1.17 | 1.0136 | 4 |
| Comparative Example 1 | 2 | 3 | 1.20 | 0.7285 | 8 |
| Comparative Example 2 | 8 | 1 | 1.20 | 1.2577 | 9 |
| Conventional Example | - | 3 | 1.16 | 1.3041 | 8 |

In the present example, the maximum wear width was smaller than that in the comparative example and the conventional example. For the nitrogen-rich TiSi nitride, it was found that those having a full width at half maximum of the (200) plane of the cubic crystal within a certain range exhibited excellent durability.

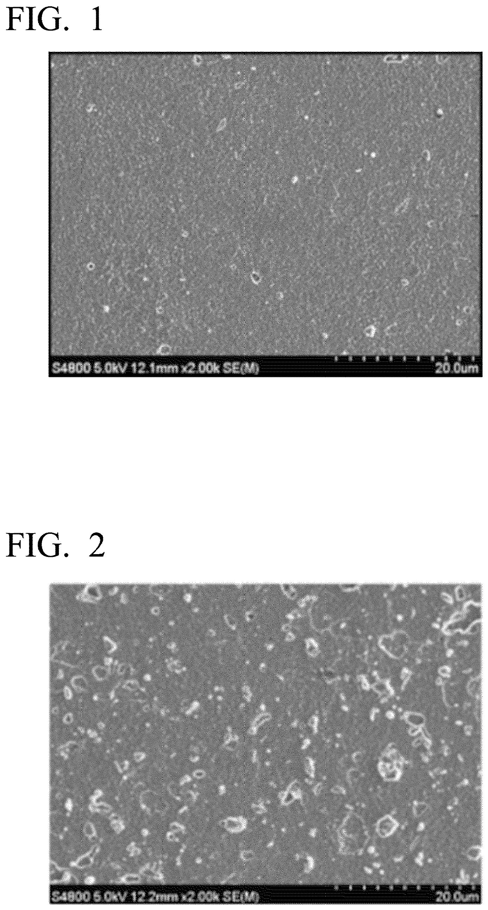

FIG. 1 shows an example of a surface observation photograph of the coated cutting tool according to the present example. FIG. 2 shows an example of a surface observation photograph of the coated cutting tool according to the conventional example. It was confirmed that the present example had fewer coarse droplets than the conventional example. Depending on the tool shape or the processing conditions, droplets significantly affect the tool performance. The coated cutting tool according to the present example is more suitable for a smaller diameter tool. It is expected that the durability is further improved compared to the conventional example by applying the present example to a small diameter tool in which the influence by the droplets is large.

## Claims

1. A coated cutting tool comprising:
a base material; and
a hard coat over the base material,
wherein the hard coat is a nitride or a carbonitride containing titanium (Ti) at 60 atom% or more and 95 atom% or less and silicon (Si) at 5 atom% or more and 40 atom% or less with respect to a total amount of metals including a metalloid, and in the hard coat, in a case where a total of metal elements including a metalloid, and non-metal elements is set to 100 atom%, an atomic ratio (atom%) A of the metal elements including the metalloid and an atomic ratio (atom%) B of nitrogen satisfy a relationship of 1.1 < B/A, and
a crystal structure is a cubic crystal and a full width at half maximum of a (200) plane of the cubic crystal in X-ray diffraction is 0.75° or more and 1.10° or less.

2. The coated cutting tool according to Claim 1,
wherein, in observation of a surface or a cross section of the hard coat, the number of droplets having an equivalent circular diameter of 3 µm or more is 5 or less in a range of 50 µm × 40 µm.

3. The coated cutting tool according to Claim 1, further comprising:
an interlayer coat provided between the hard coat and the base material.
